# FASCICULE DE BREVET EUROPEEN

(11) **EP 0 913 002 B1**
(45) Date de publication et mention de la délivrance du brevet: **18.06.2008**
(21) Numéro de dépôt: 97921902.9
(22) Date de dépôt: 29.04.1997
(51) Int. Cl.: H01L 31/0352, H01L 27/146

(54) **DETECTEUR INFRAROUGE BICOLORE A COHERENCE SPATIO-TEMPORELLE PLANAIRE**
ZWEIFARBIGER INFRAROTDETEKTOR MIT RÄUMLICH-ZEITLICHER KOHÄRENZ
BICOLOR INFRARED DETECTOR WITH SPATIAL/TEMPORAL COHERENCE

(43) Date de publication de la demande: 06.05.1999
(73) Titulaire: COMMISSARIAT A L'ENERGIE ATOMIQUE, 75015 Paris (FR)
(72) Inventeur: ZANATTA, Jean-Paul, F-38000 Grenoble (FR); FERRET, Pierre, F-38000 Grenoble (FR); DUVAUT, Philippe, F-38120 Saint-Egrève (FR)
(74) Mandataire: Audier, Philippe André
(86) Numéro de dépôt international: PCT/FR1997/000760
(87) Numéro de publication internationale: WO 1998/049734

(56) Documents cités:
- EP-A- 0 475 525
- GB-A- 2 284 930
- US-A- 4 910 154
- US-A- 4 956 686
- US-A- 5 113 076
- US-A- 5 360 987

## Description

### Domaine technique

La présente invention se rapporte à un détecteur infrarouge bicolore à cohérence spatio-temporelle ainsi qu'à son procédé de fabrication.

Dans un dispositif de détection bicolore à cohérence spatiale et temporelle, des photons infrarouges provenant de deux bandes de longueurs d'onde différentes sont détectés à un même endroit dans un plan focal du détecteur et en même temps. Les détecteurs infrarouges bicolores trouvent de nombreuses applications notamment dans la réalisation de caméras infrarouges ainsi que dans l'étude de l'atmosphère, les observations de la Terre ou d'autres applications dans le domaine spatial.

### Etat de la technique antérieure

On connaît une grande variété de détecteurs infrarouges dont la réalisation spécifique permet de privilégier certaines caractéristiques de détection. Les détecteurs infrarouges bicolores peuvent ainsi être jugés selon différents critères tels que leurs performances, leur coût de réalisation, leur compacité mais aussi la technologie de leur fabrication. Bien évidemment, tous ces critères dépendent plus ou moins les uns des autres et il est difficile de tous les optimiser simultanément. Un premier exemple de détecteur infrarouge bicolore connu est donné par le document (1) référencé à la fin de la présente description. Ce détecteur comporte un empilement d'un certain nombre de couches de matériau semi-conducteur qui forment deux diodes de détection polarisées en opposition l'une par rapport à l'autre et accouplées par des zones ou des couches dopées de type N, c'est-à-dire dopées avec des impuretés du type donneur. Comme la plupart des détecteurs infrarouges, les couches de matériau semi-conducteur sont des couches minces de composé CdHgTe, c'est-à-dire de composé Cadmium-Mercure-Tellure, ou CMT, épitaxiées sur un substrat. Le détecteur est réalisé selon la technologie dite "MESA". On désigne par technologie "MESA" une réalisation d'un dispositif à semi-conducteurs où la délimitation des couches actives est effectuée par une gravure qui laisse subsister un certain nombre de "reliefs". Cette gravure peut être soit mécanique, par exemple une abrasion mécanique, ou chimique dans le cas du détecteur bicolore du document (1). La gravure permet de définir des points de détection ou pixels qui présentent une hauteur de l'ordre d'une dizaine de micromètres.

La réalisation des détecteurs selon la technologie "MESA" présente un certain nombre de difficultés. La réalisation de dispositifs intégrés à semi-conducteurs et particulièrement la réalisation de détecteurs infrarouges nécessite un certain nombre d'étapes dites de photolithographie qui consistent à déposer sur la structure des motifs de masque pour en protéger certaines parties et définir les composants à réaliser, ou encore des étapes dites de couchage de résine qui servent également à protéger certaines parties de la structure. Les motifs de masque ne peuvent être correctement réalisés de façon simultanée à différentes hauteurs ou altitudes du dispositif, c'est-à-dire à la fois au sommet et au pied d'un pixel de détection MESA par exemple. De même, lors des étapes de couchage de résine, il est difficile d'obtenir une épaisseur homogène et constante. Des imprécisions dans la réalisation des motifs par photomasquage et des couches de résine lors des étapes de la fabrication du détecteur ne permettent pas une bonne définition de petits motifs.

Par ailleurs, dans le document (1), différentes couches empilées, qui forment le détecteur et donc les jonctions des diodes de détection, débouchent sur le côté du pixel. La passivation du pixel est donc d'autant plus difficile qu'elle doit être réalisée sur un flanc en pente, ce qui peut provoquer des fuites électriques au niveau des jonctions. On peut noter enfin, que, dans le document (1), la couche de contact commun des pixels est réalisée en un matériau de type P. Un tel matériau présente une mobilité des porteurs (trous) inférieure à celle des matériaux de type N (électrons) et par conséquent une plus grande résistivité.

Le document (2) référencé également à la fin de la présente description donne un deuxième exemple de détecteur infrarouge bicolore. Le dispositif décrit dans ce document comporte deux diodes branchées en série, polarisées en inverse et destinées respectivement à la mesure de photons infrarouges de grande et de petite longueur d'onde. Il est formé par un empilement d'une couche de composé CdHgTe dopée N, d'une couche de CdHgTe dopée P puis d'une couche CdHgTe dopée N. Toutefois, le photocourant de la diode des grandes longueurs d'onde ne peut pas être lu en même temps que celui de la diode des longueurs d'onde plus courtes. Le dispositif n'est donc pas à cohérence temporelle.

Un autre exemple encore est donné par le document (3) toujours référencé à la fin de la description. Le détecteur selon ce document comporte des structures enterrées qui permettent une technologie dite "planar" par opposition à la technologie "MESA", la technologie planar consiste en la réalisation locale de couches actives sur la surface d'un substrat en effectuant des diffusions, des implantations ou des épitaxies à travers des masques. Des éléments de détection sensibles d'une part aux petites et d'autre part aux grandes longueurs d'onde sont réalisés cependant les uns à côté des autres dans le plan focal. La détection n'est donc, dans ce cas, pas à cohérence spatiale. De plus, les éléments de détection décrits dans ce document sont du type MIS (Metal Isolant Semiconducteur) qui s'avèrent moins performants du point de vue de la réalisation que des éléments de type photovoltaïque.

Au même titre que le document (3), on peut citer le document (4) qui concerne un détecteur infrarouge sensible à plusieurs longueurs d'ondes différentes, mais où les éléments de détection correspondant à ces longueurs d'ondes sont également disposés les uns à côtés des autres.

Un but de la présente invention est de proposer un détecteur infrarouge bicolore qui soit à la fois à cohérence spatiale et temporelle et qui ne présente pas les inconvénients précédemment évoqués.

Un autre but de l'invention est de proposer un procédé de réalisation du détecteur qui soit à la fois d'une réalisation simple et qui permette d'éviter les inconvénients mentionnés ci-dessus.

### Exposé de l'invention

A cet effet, l'invention concerne plus précisément un détecteur infrarouge bicolore planaire selon la revendication 1.

Selon un aspect de l'invention, les matériaux utilisés pour les différentes couches du détecteur sont des matériaux CMT.

On entend par matériau CMT un alliage comportant les éléments Cadmium (Cd) Mercure (Hg) et Tellure (Te). De façon avantageuse, il est possible d'ajuster l'énergie de la bande interdite de ces matériaux en jouant sur la composition chimique de l'alliage, et donc de sélectionner les longueurs d'onde auxquelles sont sensibles les éléments de détection.

Comme chaque couche du détecteur comporte une partie affleurante sur une surface plane, il est plus facile de réaliser des connexions électriques pour relier le détecteur à un circuit électronique de mesure par exemple.

Selon une réalisation particulière avantageuse de l'invention, les couches de matériau du premier type de conduction sont dopées N, c'est-à-dire avec des impuretés ou des défauts de type donneur fournissant des porteurs électriques de charge négative. Les couches du second type de conduction sont par contre dopées P, c'est-à-dire avec des impuretés ou des défauts de type accepteur capables de fournir des porteurs électriques de charge positive.

Il est bien sûr possible selon une autre réalisation de choisir les couches de matériau du premier type de conduction dopées P et les couches de matériau du second type de conduction dopées N.

La présente invention a également pour objet un procédé de réalisation du détecteur précédent. Ce procédé comporte les opérations successives suivantes :
a) réalisation dans une surface d'un substrat, d'au moins une dépression avec une profondeur D,
b) formation sur la surface et dans la dépression respectivement d'une première couche d'un matériau d'un premier type de conduction, d'une seconde et d'une troisième couches d'un matériau d'un second type de conduction, la seconde couche présentant une épaisseur inférieure à la profondeur D,
c) planarisation des couches selon un plan parallèle à la surface du substrat et passant par chacune des couches formées, en préservant une partie de la première couche sur la surface du substrat,
d) réalisation d'une région du premier type de conduction dans une partie de la troisième couche subsistant après la planarisation selon un procédé du type planar, la région formant une quatrième couche étant séparée de la deuxième couche par la troisième couche,
e) réalisation de contacts ohmiques sur les première et troisième couches et sur la région du premier type de conduction.

La description qui suit se réfère chaque fois à un seul élément de détection du détecteur. A chacun de ces éléments correspond une dépression dans la surface du substrat. Bien entendu, le détecteur peut comporter un grand nombre de ces éléments de détection appelés aussi pixels. A titre d'exemple, le détecteur peut se présenter sous la forme d'une matrice de 128x128 pixels avec un pas de 70 µm. A cette matrice de détecteurs sont associés un ou plusieurs circuits dits de "lecture", ces circuits pouvant, par exemple, être associés au détecteur par une méthode d'hybridation par plot de connexion.

L'éclairage du détecteur et donc des éléments de détection se fait de préférence par une surface libre du substrat sensiblement perpendiculaire à l'empilement. Cette surface est désignée par face arrière dans la suite de la description.

A cet effet, le substrat est réalisé préférentiellement en un matériau transparent aux longueurs d'onde des rayonnements infrarouges qui doivent être détectés, par exemple en un composé cadmium, zinc, tellure. Il est possible également de réaliser le substrat en un matériau opaque aux longueurs d'onde mentionnées. Dans ce cas, le substrat est éliminé lorsque le détecteur est activé pour que la lumière atteigne directement la première couche initialement formée sur le substrat.

Dans une variante de réalisation du détecteur dans lequel l'ordre des différentes parties est inversé, il est possible de prévoir un éclairage par la surface plane où affleurent les couches de l'empilement.

La partie de la première couche préservée sur la surface du substrat sert à relier électriquement entre eux les éléments de détection du détecteur. Ainsi une électrode commune à toutes les diodes de détection peut être formée sur la couche 116 qui est une couche commune à tous les éléments de détection.

Lorsque cette couche commune est en un matériau semi-conducteur dopé N, c'est-à-dire où les porteurs majoritaires sont des électrons, la résistance série du dispositif diminue. Ceci améliore les caractéristiques de la détection dans la première photodiode.

D'autres caractéristiques et avantages de l'invention ressortiront mieux de la description qui va suivre, donnée à titre illustratif et non limitatif, en référence aux dessins annexés sur lesquels :

### Brève description des figures

- la figure 1 est une coupe schématique d'un élément de détection d'un détecteur conforme à l'invention,
- la figure 2 est un schéma électrique équivalent d'un élément de détection d'un détecteur conforme à l'invention,
- la figure 3 est une coupe d'une variante d'un élément de détection d'un détecteur conforme à l'invention,
- les figures 4A à 4D sont des coupes illustrant le procédé de fabrication d'un élément de détection d'un détecteur conforme à l'invention.

### Description détaillée de modes de mise en oeuvre de l'invention

Pour des raisons de clarté les figures et les parties qui les composent ne sont pas représentées à l'échelle.

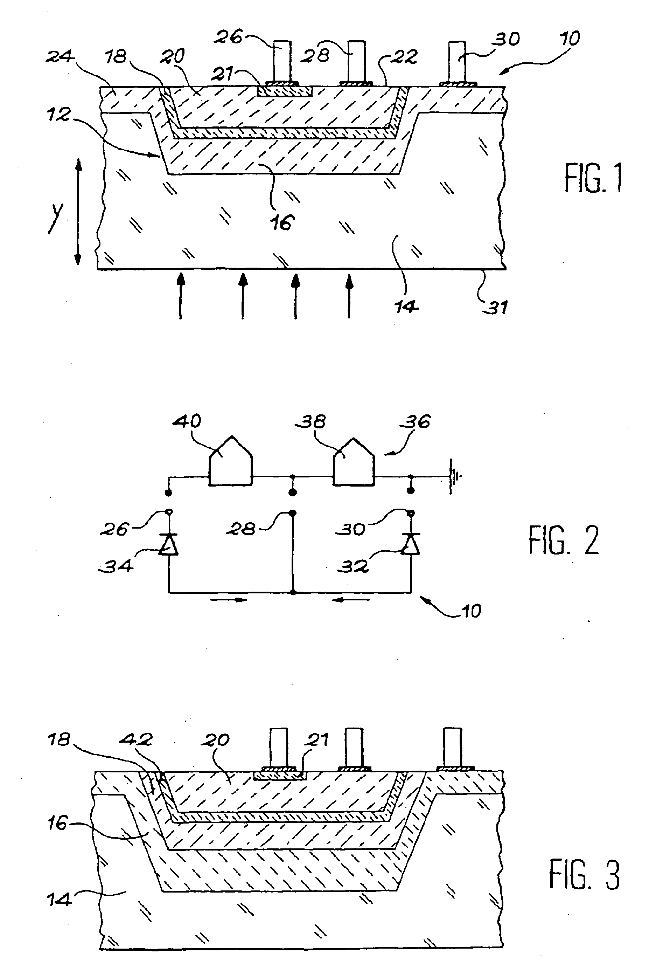

Comme le montre la figure 1, un élément de détection 10 du détecteur est réalisé dans une dépression 12 du substrat 14. Il comporte une couche 16 d'un matériau d'un premier type de conduction, par exemple un matériau N, une couche 20 d'un matériau d'un second type de conduction, par exemple P, séparée de la couche 16 par une couche 18 formant un caisson et qui est elle aussi en un matériau du second type de conduction. Il ne s'agit pas nécessairement d'un caisson fermé, mais le caisson doit séparer la couche 20 de la couche 16. L'élément de détection comporte une autre couche 21 du premier type de conduction qui est formée dans la couche 20 et que la couche 20 sépare de la couche 18.

Comme on le voit sur la figure 1, chaque couche de matériau semi-conducteur comporte une zone affleurant sur une surface plane 22 de l'élément de détection. Chaque élément de détection est donc composé d'un empilement de couches ou parties semi-conductrices qui affleurent sur la surface 22 sensiblement perpendiculaire à la direction de l'empilement. L'empilement des différentes parties garantit la cohérence spatiale de la détection. La couche 16 et la couche 18 forment une première diode de détection du rayonnement infrarouge de petites longueurs d'onde, par exemple dans la gamme de 3 à 5 µm. La couche 20 et la couche 21 forment une seconde diode de détection des longueurs d'onde plus importantes dans la gamme par exemple de 8 à 12 µm.

L'éclairage du détecteur ou de l'élément de détection se fait par une face 31, dite face arrière, et de préférence dans une direction y sensiblement parallèle à la direction de l'empilement, c'est-à-dire perpendiculairement à la face 31.

Grâce à l'empilement des différentes parties de l'élément de détection, les diodes ne sont pas juxtaposées mais superposées, ce qui assure la cohérence spatiale de la détection. De plus, les deux diodes sont branchées en série et en polarisation électrique opposée.

Les matériaux utilisés pour réaliser les différentes parties du détecteur ainsi que l'épaisseur des couches de même que leur dopage sont résumés à titre d'exemple dans le tableau I.

**TABLEAU I**

| **PARTIE** | **MATERIAU** | **EPAISSEUR** | **TYPE DE DOPAGE** | **DENSITE DE DOPAGE** |
|---|---|---|---|---|
| **SUBSTRAT** | Cd_{0.96}Zn_{0.04}Te | | | |
| **COUCHE 16** | Cd_{0.30}Hg_{0.70}Te | 5 µm | N | 10¹⁷/cm³ |
| **COUCHE 18** | De_{0.30}Hg_{0.70}Te | 2 µm | P | 10¹⁶/cm³ |
| **COUCHE 20** | Cd_{0.22}Hg_{0.78}Te | 7 µm | P | 10¹⁶/cm³ |
| **COUCHE 21** | Cd_{0.22}Hg_{0.78}Te | 2 µm | N (implantation) | |

Les compositions et les paramètres donnés au tableau I doivent être compris comme des ordres de grandeurs et ne sont donnés qu'à titre indicatif. Les couches actives de l'élément de détection peuvent, de façon plus générale être choisies parmi des composés III-V, II-V, IV-IV ou IV-VI (les chiffres romains indiquent des éléments des colonnes correspondantes du tableau périodique de classification des éléments), le choix et la combinaison des matériaux étant pour l'essentiel dicté par la gamme de longueurs d'onde à détecter.

De même, le substrat peut être un alliage semi-conducteur d'éléments II-VI tels que CdTe, ZnTe, d'éléments III-V, tels que AsGa ou d'éléments IV-IV à base de silicium par exemple. Il peut également être en saphir ou une combinaison de certains des matériaux cités. En outre, et en particulier pour la diode de détection du rayonnement de petite longueur d'onde, il est possible de réaliser une hétérojonction où la partie P est de nature différente de la partie N pour améliorer les performances de l'élément de détection.

Comme le montre la figure 1, sur la surface 22 de l'élément de détection sensiblement parallèle à la face arrière 31, sont formées des prises de contact 26, 28 et 30 respectivement en contact électrique avec la couche 21, la couche 20 et la couche 16. Ces contacts sont prévus pour être reliés à un circuit d'exploitation des mesures du détecteur. La connexion à un circuit de lecture ou d'exploitation des mesures peut par exemple être effectuée par des plots métalliques d'indium formés sur les contacts.

Pour une description plus détaillée de cette technique de connexion, on peut se référer avantageusement au document (5) référencé à la fin de la description. A ce sujet, la figure 2 permet de mieux comprendre le fonctionnement électrique du détecteur ainsi que ses connexions avec un circuit de lecture.

Sur la figure 2, les première et seconde diodes, c'est-à-dire, d'une part, la diode formée entre la couche 16 et la couche 18 et, d'autre part, la diode formée par les couches 20 et 21, sont représentées avec les références 32 et 34. Ces deux diodes, montées tête-bêche, ont en commun, sur l'élément de détection, le contact 28 qui est relié à la couche 20. L'élément de détection 10 est relié à un circuit de sortie 36 qui comporte une première sortie 38 et une deuxième sortie 40. La première sortie 38 est associée à la diode 32 de détection du rayonnement infrarouge de plus petite longueur d'onde et la deuxième sortie 40 associée à la diode 34 correspond à la détection du rayonnement infrarouge de plus grande longueur d'onde.

Sur la figure 3, qui est une variante de réalisation du détecteur, des éléments identiques portent les mêmes références que sur la figure 1. On peut noter sur la figure 3 une couche supplémentaire 42 intercalée entre la couche 18 et la couche 20. La couche 42 dédouble le caisson de la couche 18. Elle est réalisée en un matériau dopé P et qui présente dans sa composition une proportion plus élevée de cadmium que le caisson ou la couche 20. La fonction de la couche supplémentaire est de faire barrière aux photoélectrons de la première photodiode qui seraient éventuellement générés dans la couche 18 et qui pourraient être lus dans la seconde photodiode.

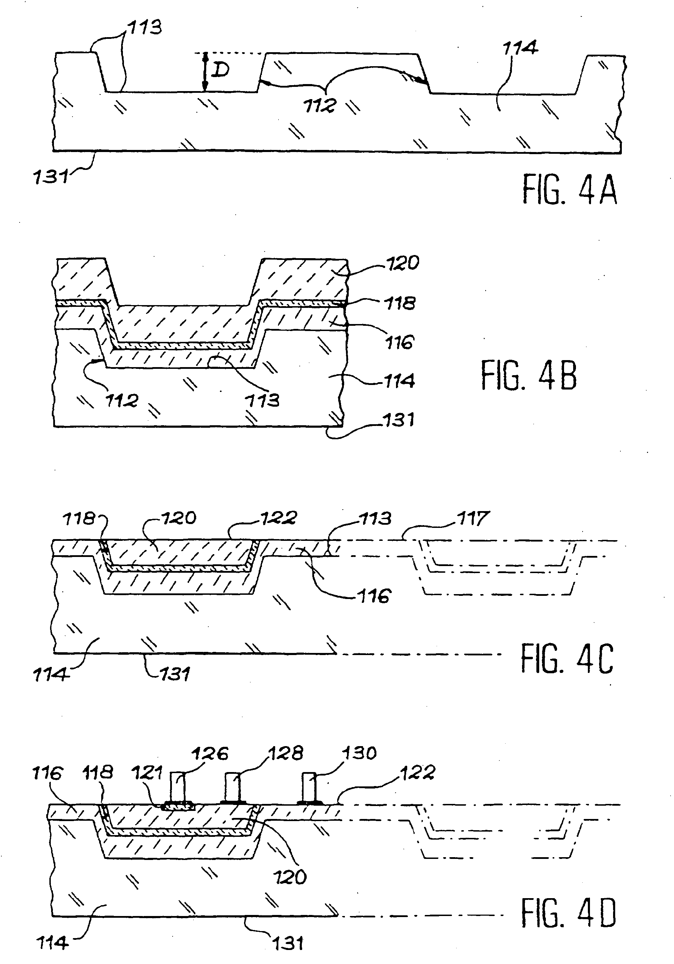

La figure 4A illustre la première étape d'un procédé de fabrication du détecteur de l'invention. Dans cette figure et dans les figures suivantes, des éléments correspondant à des éléments des figures 1 à 3 portent des références également correspondantes auxquelles on a ajouté 100. Dans une surface 113 d'un substrat 114, on grave une ou plusieurs dépressions 112 qui définissent l'emplacement des éléments de détection. La profondeur des dépressions dépend de l'épaisseur des couches qui vont être déposées par la suite. A titre d'exemple, cette profondeur pourra être de 11 µm, ce qui correspond aux épaisseurs des couches mentionnées dans le tableau I. Les dépressions peuvent être réalisées par gravure, par voie chimique ou par voie sèche. Lorsque le détecteur se présente comme une barrette de plusieurs éléments de détection ou comme une matrice d'éléments de détection ou pixels, les dépressions sont gravées en fonction du pas de cette matrice selon un motif périodique répété. A titre d'exemple, les dépressions peuvent être gravées avec une périodicité spatiale de 70 µm. Lorsque le substrat est ainsi gravé, on y forme les couches actives, c'est-à-dire des couches de matériau semi-conducteur qui vont former les différentes parties de l'élément de détection.

Comme le montre la figure 4B, on forme sur la surface 113 successivement une couche 116 de matériau du premier type de conduction par exemple N, une deuxième couche 118 d'un matériau d'un second type de conduction, soit P, puis une troisième couche 120 d'un matériau toujours du deuxième type de conduction. Les couches sont formées par épitaxie, par exemple selon un procédé d'épitaxie par jet moléculaire dit MBE ("Molecular Beam Epitaxy"). D'autres techniques de croissance telles que l'épitaxie en phase vapeur VPE ("Vapor Phase Epitaxy") ou le dépôt assisté par des précurseurs organométalliques MOCVD ("Metal Organic Chemical Vapor Deposition") peuvent également être envisagées. En ce qui concerne les opérations technologiques de formation des couches, on peut se référer avantageusement aux documents (6) et (7) référencés à la fin de la description.

Les matériaux utilisés pour les couches 116, 118 et 120 sont des matériaux désignés pour les couches correspondantes 16, 18 et 20 de la figure 1.

Après la formation des couches 116, 118 et 120, l'ensemble est usiné du côté de la couche 120, par exemple par gravure plasma par voie chimique, par abrasion mécanique, par usinage ionique ou une combinaison de ces techniques d'usinage. Cette gravure permet de définir sur la structure une surface plane 122 visible à la figure 4C. Elle est sensiblement perpendiculaire à l'empilement des couches.

La structure comporte, comme on peut le voir sur la figure 4C, à présent une couche 116 en un matériau dopé N, un caisson formé par la couche 113 et une région dopée P qui provient de la couche 120. Lorsque le détecteur comporte plusieurs éléments de détection, lors de la gravure, une partie 117 de la couche 116 est préservée sur la surface 113 du substrat 114 pour assurer une continuité électrique entre les éléments de détection. A cet effet, la gravure de planarisation est arrêtée après avoir éliminé une épaisseur de 1 à 2 µm de la couche 116. La couche 116 est ainsi une couche commune pour tous les éléments de détection.

Après obtention de la surface plane 122, on forme dans la couche 120 une région dopée N qui porte la référence 121. Cette région constitue la quatrième couche déjà définie dans ce qui précède. Cette couche 121 représentée à la figure 4D forme, avec la couche 120, la diode détectant les grandes longueurs d'onde. Elle peut être réalisée soit par diffusion soit par implantation. On peut se référer à ce titre aux documents (8) et (9) cités à la fin de la description. Grâce à cet aspect, la jonction N-P de la photodiode sensible aux grandes longueurs d'onde du rayonnement infrarouge, effectuée dans un matériau de petite bande interdite débouche sur une surface plane qui est donc facile à isoler électriquement ou à passiver. Il est possible ainsi de diminuer les problèmes de fuite électrique au niveau de cette jonction.

La fabrication du détecteur se poursuit par la formation de prises de contact 126, 128, 130. Ces contacts correspondent aux contacts 26, 28 et 30 des figures précédentes.

L'éclairage de la structure peut avoir lieu par la face du substrat référencée 131 sur les figures 4A à 4D. Toutefois, selon un mode de mise en oeuvre particulier de l'invention, le procédé de fabrication peut être poursuivi par l'élimination du substrat pour mettre à nu la couche 116, qui reçoit donc directement le rayonnement infrarouge. Le substrat peut être éliminé par exemple par polissage ou attaque chimique.

### DOCUMENTS CITES DANS LA DEMANDE

**(1)** Independantly Accessed Back-to-Back HgCdTe photodiodes : A New Dual Band Infrared Detector I.B. Bath and al. - Resselaer Polytechnic Institute, Troy, New Ycrk, 12180, 1993 U.S. Workshop on the physics and chemistry of Mercury Cadmium Telluride and other IR materials - Seattle (Washington).
**(2)** US-A-5 113 076
**(3)** US-A-4 956 686
**(4)** EP-A-0 475 525
**(5)** FR-A-2 646 558
**(6)** Molecular Beam Epitaxy of II-VI Compounds : CdₓHg₁₋ₓTe, J.P. Faurie and A. Million, Journal of Crystal Growth 54 (1981) 582-585.
**(7)** HgCdTe Double Heterostructure for Infrared Injection Laser. A. Million et al., Journal of Crystal Growth 127 (1993) 291-295.
**(8)** Semiconductor and Semimetals. R.K. Willardian, A.C. Beer, vol. 18, Academic Press 1981, pp. 273-283.
**(9)** Advanced Infrared Focal Plane Array, D. Amingual, SPIE, vol. 1512, Infrared and Optoelectronic Materials and Devices (1991).

## Revendications

1. Détecteur infrarouge bicolore planaire, avec au moins un élément de détection comportant selon une direction (y) un empilement de couches (16, 116, 18, 118, 20, 120, 21, 121) semi-conductrices formant une première et une seconde photodiodes (32, 34) , ce détecteur présentant une structure planaire où chaque couche comporte une partie affleurante sur une surface (22) de l'élément de détection, la surface (22) étant sensiblement perpendiculaire à la direction (y), les photodiodes étant montées en tête bêche et ayant en commun un contact (28)
**caractérisé en ce que**:
a) - il est à cohérence spatio-temporelle, des photons infrarouges de deux bandes de longueurs d'onde différentes pouvant ainsi être détectés à un même endroit dans un plan focal du détecteur et en même temps,
b) - **en ce que** l'empilement comporte une première couche (16, 116) en un matériau d'un premier type de conduction, au moins une deuxième couche (18, 118) en un matériau d'un second type de conduction, une troisième couche (20, 120) en un matériau du second type de conduction, séparée de la première couche (16, 116) par la deuxième couche, et une quatrième couche (21, 121) en un matériau du premier type de conduction, séparée de la deuxième couche (18, 118) par la troisième couche (20, 120), la première et la troisième couches formant respectivement avec la deuxième et la quatrième couches la première et la seconde photodiodes (32, 34),
c) - et **en ce qu'**il comporte une prise de contact (30, 130) avec la première couche (16, 116), une prise de contact (28, 128) avec la troisième couche (20, 120) et formant ledit contact commun aux photodiodes, et une prise de contact (26, 126) avec la quatrième couche (21, 121).

2. Détecteur infrarouge selon la revendication 1, les couches étant réalisées en des alliages de cadmium, de mercure et de tellure.

3. Détecteur infrarouge selon la revendication 1 ou 2, le premier type de conduction étant une conduction par porteurs électriques de charge positive (dopage P) et le second type de conduction étant une conduction par porteurs électriques de charge négative (dopage N).

4. Détecteur infrarouge bicolore selon l'une des revendications 1 à 3, comportant un substrat (14, 114) de support de la première couche (16, 116), qui est transparent au rayonnement infrarouge.

5. Détecteur infrarouge selon l'une des revendications 1 à 4, la première photodiode (32) et la seconde photodiode (34) étant respectivement sensible dans un premier et un second spectres de rayonnement infrarouge, le premier spectre correspondant à des longueurs d'onde inférieures à celles du second spectre.

6. Détecteur infrarouge selon l'une des revendications 1 à 5, comportant une pluralité d'éléments de détection (10) reliés électriquement entre eux par une couche commune (16, 116) de matériau formant respectivement la première couche de chaque élément.

7. Détecteur infrarouge selon la revendication 6, comportant une pluralité d'éléments de détection (10) disposés selon des lignes et/ou des colonnes d'une matrice de pixels.

8. Détecteur infrarouge selon l'une des revendications 1 à 7, comportant en outre une couche barrière (42) en un matériau du second type de conduction intercalée entre la deuxième et la troisième couche.

9. Procédé de fabrication d'un détecteur infrarouge bicolore à cohérence spatio-temporelle selon l'une des revendications 1 à 8, comportant les opérations successives suivantes :
a) réalisation dans une surface (112) d'un substrat (114), d'au moins une dépression avec une profondeur D,
b) formation sur la surface et dans la dépression respectivement d'une première couche (116) d'un matériau d'un premier type de conduction, d'une seconde couche (118) et d'une troisième couche (120) d'un matériau d'un second type de conduction, la seconde couche présentant une épaisseur inférieure à la profondeur D,
c) planarisation des couches selon un plan parallèle à la surface du substrat et passant par chacune des couches formées, en préservant une partie de la première couche (116) sur la surface (113) du substrat (114),
d) réalisation d'une région (121) du premier type de conduction dans une partie de la troisième couche subsistant après la planarisation selon un procédé du type planar, la région (121) formant une quatrième couche et étant séparée de la deuxième couche par la troisième couche,
e) réalisation de contacts ohmiques (126, 128, 130) sur les première et troisième couches et sur la région (121) du premier type de conduction réalisée dans une partie de la troisième couche.

10. Procédé de fabrication selon la revendication 9, comportant en outre l'élimination du substrat après l'opération e).

11. Procédé selon la revendication 9 ou 10, le premier type de conduction étant une conduction par porteurs électriques de charge positive (dopage P) et le second type de conduction étant une conduction par porteurs électriques de charge négative (dopage N).

12. Procédé selon l'une des revendications 9 à 11, dans lequel, lors de l'étape d), la région (121) du premier type de conduction étant formée par diffusion ou par implantation.

## Claims

1. A planar bicolor infrared detector, with at least one detection element including along a direction (y), a stack of semiconducting layers (16, 116, 18, 118, 20, 120, 21, 121) forming first and second photodiodes (32, 34), this detector having a planar structure where each layer includes a flushing portion on a surface (22) of the detection element, the surface (22) being substantially perpendicular to the direction (y), the photodiodes being mounted head to tail and having a contact (28) in common,
**characterized in that**:
a) - it has space-time coherence, infrared photons of two different ranges of wavelengths being thereby detectable at a same location in a focal plane of the detector and at the same time,
b) - **in that** the stack includes a first layer (16, 116) in a material of a first type of conduction, at least a second layer (18, 118) in a material of a second type of conduction, a third layer (20, 120) in a material of the second type of conduction, separated from the first layer (16, 116) by the second layer, and a fourth layer (21, 121) in a material of the first type of conduction, separated from the second layer (18, 118) by the third layer (20, 120), the first and third layers forming with the second and fourth layers, the first and second photodiodes (32, 34), respectively,
c) - and **in that** it includes a contact connection (30, 130) with the first layer (16, 116), a contact connection (28, 128) with the third layer (20, 120) and forming said contact common to the photodiodes, and a contact connection (26, 126) with the fourth layer (21, 121) .

2. The infrared detector according to claim 1, the layers being made in cadmium, mercury and tellurium alloys.

3. The infrared detector according to claim 1 or 2, the first type of conduction being a conduction by positive electric charge carriers (P doping) and the second type of conduction being a conduction by negative electric charge carriers (N doping).

4. The bicolor infrared detector according to any of claims 1 to 3, including a substrate (14, 114) supporting the first layer (16, 116), which is transparent to infrared radiation.

5. The infrared detector according to any of claims 1 to 4, the first photodiode (32) and the second photodiode (34) being sensitive in first and second infrared radiation spectra respectively, the first spectrum corresponding to smaller wavelengths than those of the second spectrum.

6. The infrared detector according to any of claims 1 to 5, including a plurality of detection elements (10) electrically connected with each other by a common layer (16, 116) of material respectively forming the first layer of each element.

7. The infrared detector according to claim 6, including a plurality of detection elements (10) positioned along lines and/or columns of a matrix of pixels.

8. The infrared detector according to any of claims 1 to 7, further including a barrier layer (42) in a material of the second type of conduction inserted between the second and the third layer.

9. A method for making a bicolor infrared detector with space-time coherence according to any of claims 1 to 8, including the following successive operations:
a) making at least one depression with depth D in a surface (112) of a substrate (114),
b) forming on the surface and in the depression, a first layer (116) of a material of a first type of conduction, a second layer (118) and a third layer (120) of a material of a second type of conduction, respectively, the second layer having a thickness less than the depth D,
c) planarizing the layers along a plane parallel to the surface of the substrate and passing through each of the formed layers, by preserving a portion of the first layer (116) on the surface (113) of the substrate (114),
d) making a region (121) of the first type of conduction in a portion of the third layer remaining after planarization according to a planar type method, the region (121) forming a fourth layer and being separated from the second layer by the third layer,
e) making ohmic contacts (126, 128, 130) on the first and third layers and on the region (121) of the first type of conduction, made in a portion of the third layer.

10. The making method according to claim 9, further including removal of the substrate after operation e).

11. The method according to claim 9 or 10, the first type of conduction being a conduction by positive electric charge carriers (P doping) and the second type of conduction being a conduction by negative electric charge carriers (N doping).

12. The method according to any of claims 9 to 11, wherein, during step d), the region (121) of the first type of conduction is formed by diffusion or implantation.

## Patentansprüche

1. Planarer Zweifarben-Infrarotdetektor, mit mindestens einem Detektionselement, aufweisend gemäß einer Richtung (y) ein Paket halbleitender Schichten (16, 116, 18, 118, 20, 120, 21, 121), eine erste und eine zweite Fotodiode (32, 34) bildend, wobei dieser Detektor eine planare Struktur aufweist, wobei jede Schicht einen auf einer Oberfläche (22) des Detektionselements bündig abschließenden Abschnitt aufweist, wobei die Oberfläche (22) etwa senkrecht zur Richtung (y) ist, wobei die Fotodioden umgekehrt montiert sind und einen Kontakt (28) gemeinsam haben,
**dadurch gekennzeichnet, dass**:
a) - er räumlich-zeitlich kohärent ist, wobei dadurch Infrarotphotonen von zwei Bändern verschiedener Wellenlängen an einer selben Stelle in einer Fokalebene des Detektors und gleichzeitig erfassbar sind,
b) - das Paket eine erste Schicht (16, 116) aus einem Material eines ersten Leitungstyps, mindestens eine zweite Schicht (18, 118) aus einem Material eines zweiten Leitungstyps, eine dritte Schicht (20, 120) aus einem Material des zweiten leitungstyps, getrennt von der ersten Schicht (16, 116) durch die zweite Schicht, und eine vierte Schicht (21, 121) aus einem Material des ersten Leitungstyps, getrennt von der zweiten Schicht (18, 118) durch die dritte Schicht (20, 120) aufweist, wobei die erste und die dritte Schicht jeweils mit der zweiten und der vierten Schicht die erste und die zweite Fotodiode (32, 34) bilden,
c) - und dadurch, dass er einen Kontaktschluss (30, 130) mit der ersten Schicht (16, 116), einen Kontaktschluss (28, 128) mit der dritten Schicht (20, 120) aufweist und den besagten gemeinsamen Kontakt mit den Fotodioden bildet, und einen Kontaktschluss (26, 126) mit der vierten Schicht (21, 121).

2. Infrarotdetektor nach Anspruch 1, wobei die Schichten aus Kadmium-, Quecksilber- und Tellurlegierungen ausgeführt sind.

3. Infrarotdetektor nach Anspruch 1 oder 2, wobei der erste Leitungstyp eine Leitung durch positiv geladene elektrische Träger (Dotierung P) ist und der zweite Leitungstyp eine Leitung durch negativ geladene elektrische Träger (Dotierung N) ist.

4. Zweifarben-Infrarotdetektor nach einem der Ansprüche 1 bis 3, ein Trägersubstrat (14, 114) der ersten Schicht (16, 116) aufweisend, das für Infrarotstrahlen durchlässig ist.

5. Infrarotdetektor nach einem der Ansprüche 1 bis 4, wobei die erste Fotodiode (32) und die zweite Fotodiode (34) jeweils in einem ersten und einem zweiten Spektrum von Infrarotstrahlen sensibel sind, wobei das erste Spektrum Wellenlängen entspricht, die kleiner sind als die Wellenlängen des zweiten Spektrums.

6. Infrarotdetektor nach einem der Ansprüche 1 bis 5, eine Vielzahl von Detektionselementen (10) aufweisend, die elektrisch durch eine gemeinsame Schicht (16, 116) aus dem Material miteinander verbunden sind, das jeweils die erste Schicht jedes Elements bildet.

7. Infrarotdetektor nach Anspruch 6, eine Vielzahl von Detektionselementen (10) aufweisend, die in Reihen und/oder Spalten einer Pixelmatrix angeordnet sind.

8. Infrarotdetektor nach einem der Ansprüche 1 bis 7, im weiteren eine zwischen die zweite und die dritte Schicht zwischengeschobene Barriereschicht (42) aus einem Material des zweiten Leitungstyps aufweisend.

9. Verfahren zur Herstellung eines räumlich-zeitlich kohärenten Zweifarben-Infrarotdetektors nach einem der Ansprüche 1 bis 8, die folgenden aufeinanderfolgenden Schritte aufweisend:
a) Realisierung in eine Oberfläche (112) eines Substrats (114), mindestens einer Vertiefung mit einer Tiefe D,
b) Ausbildung auf der Oberfläche und in der Vertiefung jeweils einer ersten Schicht (116) aus einem Material eines ersten Leitungstyps, einer zweiten Schicht (118) und einer dritten Schicht (120) aus einem Material eines zweiten Leitungstyps, wobei die zweite Schicht eine Dicke aufweist, die kleiner ist als die Tiefe D,
c) Planarisierung der Schichten gemäß einer Ebene, die parallel zur Oberfläche des Substrats ist und durch jede der gebildeten Schichten Verläuft, bei Bewahrung eines Abschnitts der ersten Schicht (116) auf der Oberfläche (113) des Substrats (114),
d) Realisierung einer Region (121) des ersten Leitungstyps in einem Abschnitt der dritten Schicht, die nach der Planarisierung gemäß einem Verfahren des planaren Typs verbleibt, wobei die Region (121) eine vierte Schicht bildet und von der zweiten Schicht durch die dritte Schicht getrennt ist,
e) Realisierung Ohmscher Kontakte (126, 128, 130) auf der ersten und dritten Schicht und auf der Region (121) des ersten Leitungstyps, die in einen Abschnitt der dritten Schicht realisiert ist.

10. Herstellungsverfahren nach Anspruch 9, im weiteren die Entfernung des Substrats nach dem Schritt e) aufweisend.

11. Verfahren nach Anspruch 9 oder 10, wobei der erste Leitungstyp eine Leitung durch positiv geladene elektrische Träger (Dotierung P) und der zweite Leitungstyp eine Leitung durch negativ geladene elektrische Träger (Dotierung N) ist.

12. Verfahren nach einem der Ansprüche 9 bis 11, wobei in Schritt d) die Region (121) des ersten Leitungstyps durch Diffusion oder durch Implantation gebildet ist.
